# EUROPEAN PATENT SPECIFICATION

(11) **EP 1 772 908 B1**
(45) Date of publication and mention of the grant of the patent: **03.10.2018**
(21) Application number: 06020946.7
(22) Date of filing: 05.10.2006
(51) Int. Cl.: H01L 31/0232, H01L 27/146, H04N 5/225, H04N 17/00

(54) **Wafer level image module, method for making the same and apparatus for assembling and testing the same**
Wafer-Level Bild-Modul, Verfahren zu dessen Herstellung und Vorrichtung für dessen Zusammenbau und Überprüfung
Module d'image au niveau de plaquette, méthode pour sa fabrication et dispositif pour son assemblage et son contrôle.

(30) Priority: 09.10.2005 CN 200510113450
(43) Date of publication of application: 11.04.2007
(73) Proprietor: VisEra Technologies Company Limited, Hsin-Chu City 30078 (TW); OmniVision Technologies, Inc., Santa Clara, CA 95054 (US)
(72) Inventor: Lee, Hsiao-Wen, Hsinchu City 300 Taiwan (CN); Zung, Pai-Chun Peter, Hsinchu Taiwan (CN); Lin, Tzu-Han, Hsinchu Taiwan (CN)
(74) Representative: Becker Kurig Straus

(56) References cited:
- EP-A- 1 244 151
- WO-A-2005/031422
- WO-A-2005/093826
- JP-A- 2000 134 528
- JP-A- 2005 057 261
- US-A1- 2005 067 681
- US-A1- 2005 110 889

## Description

### BACKGROUND OF THE INVENTION

### 1. Field of the Invention

The present invention relates to image modules and more particularly, to a wafer level image module, the method for making the same and the apparatus for assembling and testing the same.

### 2. Description of the Related Art

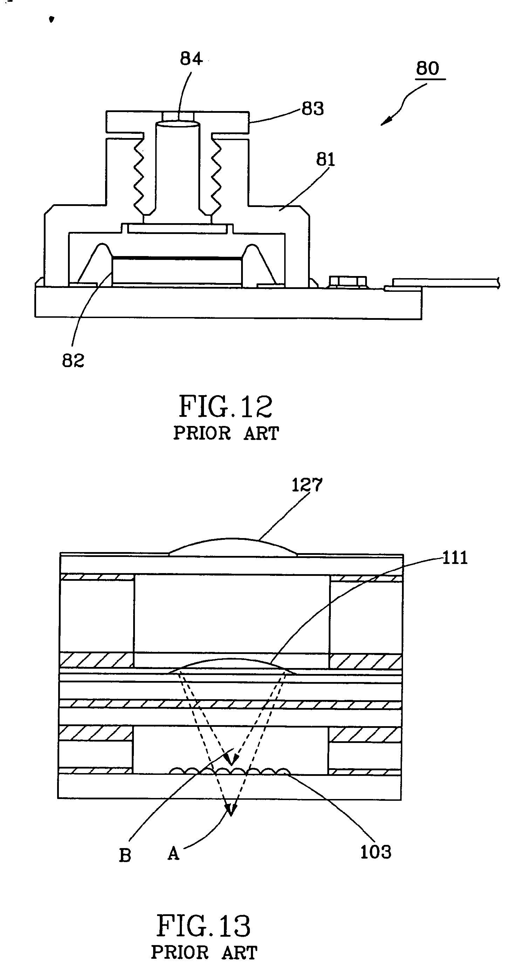

FIG. 12 shows a conventional CMOS (Complementary Metal-Oxide Semiconductor) image module 80. According to this design, the CMOS image module 80 comprises a sensor chip 82 and a lens holder 81 covering the sensor chip 82. The lens holder 81 comprises a rotary lens barrel 83, and a lens set 84 on the center of the rotary lens barrel 83. When the lens set 84 is mapping an image onto the sensor chip 82, the rotary lens barrel 83 is rotatable to change the distance between the lens set 84 and the sensor chip 82, thereby focusing light rays on the sensor chip 82.

FIG. 13 shows an image module according to WO2004/027880. This design of image module comprises an image pickup device 103 and a set of lenses 111 and 127. The lenses 111 and 127 are arranged in a stack and closely attached to the image pickup device 103 to map the image of incident light rays onto the image pickup device 103. The main feature of this patent is that the image pickup device 103 and the lenses 111 and 127 are made through an integrated circuit manufacturing process to minimize the size for use in a cell phone, PDA, or any of a variety of other consumer electronics.

However, during the fabrication of the image module according to WO2004/027880, the lenses 111 and 127 may deform by the manufacturing process and the manufacturing temperature. The focal distance of the finished product shows a 0-50 *µ*m error when compared to the original theoretical design. In actual practice, the lenses 111 and 127 cannot accurately focus the image of incident light rays onto the image pickup device 103, resulting in an out-of-focus problem (see the imaginary line A or B in FIG. 13). Further, when mounting the lenses 111 and 127 on the image pickup device 103, the respective size tolerance, for example, 0-20 *µ*m thickness tolerance of each glass chip makes distance control between the lenses111 and 127 and the image pickup device 103 difficult, resulting in inaccurate focusing of the lenses 111 and 127 on the image pickup device 103.

Each of documents US 2005/067681 A1, US 2005/110889 A1, EP 1 244 151 A and WO 2005/031422 A discloses a wafer level image module. Each of documents WO 2005/093826 A, JP 2000 134528 A and JP 2005 057261 A discloses an apparatus for in-situ assembling and testing a wafer level image module.

### SUMMARY OF THE INVENTION

The present invention has been accomplished under the circumstances in view. It is an objective of the present invention to provide a wafer level image sensor, which has adjustment means to compensate focus offset, thereby improving the image mapping quality.

It is another objective of the present invention to provide a wafer level image sensor assembly apparatus, which allows in-situ adjustment and test of each assembled wafer level image sensor, assuring a high quality of each assembled wafer level image sensor.

It is still another objective of the present invention to provide a wafer level image sensor assembly method, which is practical to assemble high quality wafer level image sensors.

To achieve these objectives of the present invention, the wafer level image module comprises the features of claim 1.

The method for making a wafer level image module comprises the steps of claim 7.

The present invention also provides an apparatus according to claim 9 for in-situ assembling and testing the aforesaid wafer level image module of claim 1. The apparatus comprises the features of claim 9.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from this detailed description.

### BRIEF DESCRIPTION OF THE DRAWING

The present invention will become more fully understood from the detailed description given hereinbelow and the accompanying drawings which are given by way of illustration only, and thus are not limitative of the present invention, and wherein:
FIG. 1 is a schematic sectional view of a wafer level image module in accordance with a first preferred embodiment of the present invention;
FIG. 2 is a perspective view of a wafer level image module assembly apparatus according to the present invention;
FIG. 3 is a schematic view showing the clamping device clamped the stacked first water and the second wafer on the test table;
FIG. 4 is a schematic side view showing the first water and the second wafer stacked together and placed on the test table;
FIG. 5 is a schematic drawing showing an out-of-focus status of an image mapped on the photo sensor according to the present invention;
FIG. 6 is similar to FIG. 4, showing the adjustment member set in between the first wafer (photo sensors) and the second wafer (lens sets);
FIG. 7 is a schematic drawing showing an image mapped onto the photo sensor after installation of the adjustment member in the wafer level image module according to the present invention;
FIG. 8 is schematic drawing showing an in-focus status of an image mapped on the photo sensor according to the present invention;
FIG. 9 is a schematic sectional view of a wafer level image module in accordance with a second preferred embodiment of the present invention;
FIG. 10 is a schematic sectional view of a wafer level image module in accordance with a third preferred embodiment of the present invention;
FIG. 11 is a schematic sectional view of a wafer level image module not forming part of the present invention;
FIG. 12 is a schematic drawing showing an image module according to the prior art, and
FIG. 13 is a schematic drawing showing another design of image module according to the prior art.

### DETAILED DESCRIPTION OF THE PREFERRED EMBODIMENT

As shown in FIG. 1, a wafer level image module **10** in accordance with a first preferred embodiment of the present invention comprises a photo sensor **20,** an adjustment member **25,** and a lens set **30.** The photo sensor **20** can be a CMOS (Complementary Metal-Oxide Semiconductor) image sensor or CCD (Charge Coupled Device) image sensor adapted to output an electrical signal when induced by light. The photo sensor **20** is mounted on the top side thereof with a light transmissive spacer **22.** The light transmissive spacer **22** protects the photo sensor **20** against outside pollutants and moisture. The adjustment member **25** is a glass ball spacer **25** formed on the top surface of the transmissive spacer **22** by sputtering deposition, spot adhesive, or screen printing. The adjustment member **25** has a thickness 1-50 *µ* m. This thickness is determined subject to the depth of focus required and the focus offset. Further, the adjustment member **25** can be formed on the transmissive spacer by means of thick film photolithography technology, or directly made of a glass plate. Alternatively, the adjustment member **25** can be formed on the lens set **30.**

The lens set **30** can be molded from transparent ultraviolet polymers, or made by etching. The lens set **30** is covered on the top side of the adjustment member **25** such that the adjustment member **25** is sandwiched between the lens set **30** and the photo sensor **20** for controlling the distance between the lens set **30** and the photo sensor **20.** Incident light rays go through the lens set **30** to the photo sensor **20,** thereby mapping the image onto the photo sensor **30.** The focus offset in which the lens set **30** maps the image of incident light rays onto the photo sensor **20** is 0-50 *µ*m. When setting the adjustment member **25** in between the lens set **30** and the photo sensor **20,** the thickness of the adjustment member **25** compensates the focus offset, thereby controlling the precision of the focal distance of the lens set **30** within the desired depth of focus. For an image module of FNO equal to 2.8 and pixel size 3.6 *µ* m, the focus precision is about 10 *µ*m. By means of the adjustment member **25** to compensate light rays, incident light rays are accurately focused on the photo sensor **20.**

When making the aforesaid wafer level image module **10,** an assembly apparatus **40** is used for in-situ assembly and in-situ test of wafer level image modules **10.** The structure of this assembly apparatus **40** is outlined hereinafter with reference to FIGS. 2 through 4.

As illustrated in FIGS. 2-4, the assembly apparatus **40** comprises a positioning unit **42,** a signal pickup device **43,** a signal processor **46,** and a bonding unit **48.** The positioning unit **42** comprises a base **50** and a test table **51.** The base **50** supports a sliding carrier **52** and a clamping device **54.** The sliding carrier **52** is movable in and out of the base **50** to carry wafer level image modules **10.** The clamping device **54** is adapted to hold wafer level image modules **10** in position and to place wafer level image modules **10** on the test table **51.** The signal pickup device **43** comprises a probe card **44.** The signal pickup device **43** is mounted in the base **50** of the positioning unit **42.** The signal processor **46** is electrically connected to the signal pickup device **43,** and adapted to check in-focus or out-of-focus status of the image signal picked up from wafer level image modules **10.** The bonding unit **48** is adapted to bond the photo sensor **20,** adjustment member **25** and lens set **30** of wafer level image modules **10.**

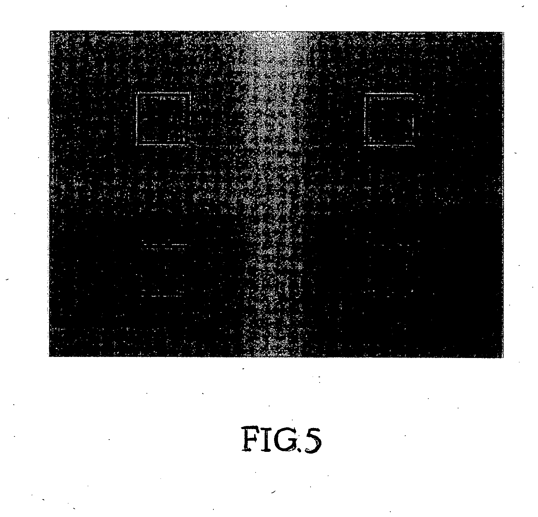

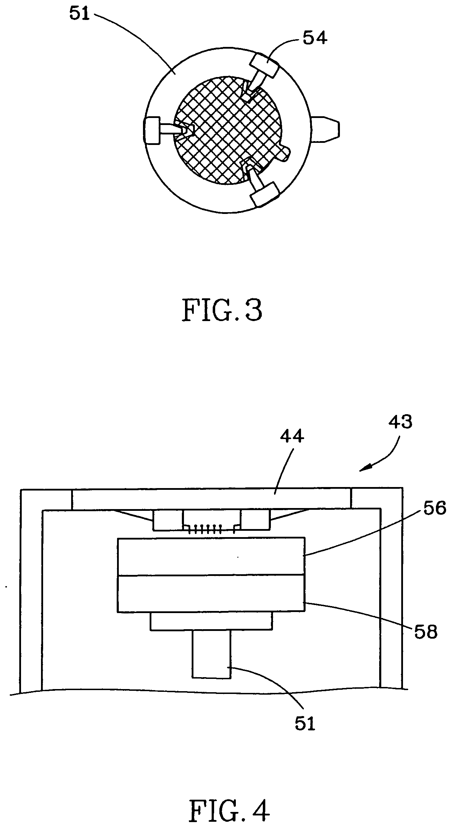

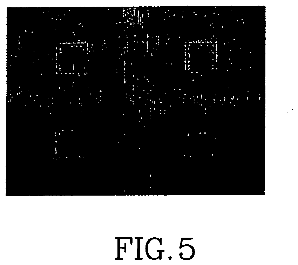

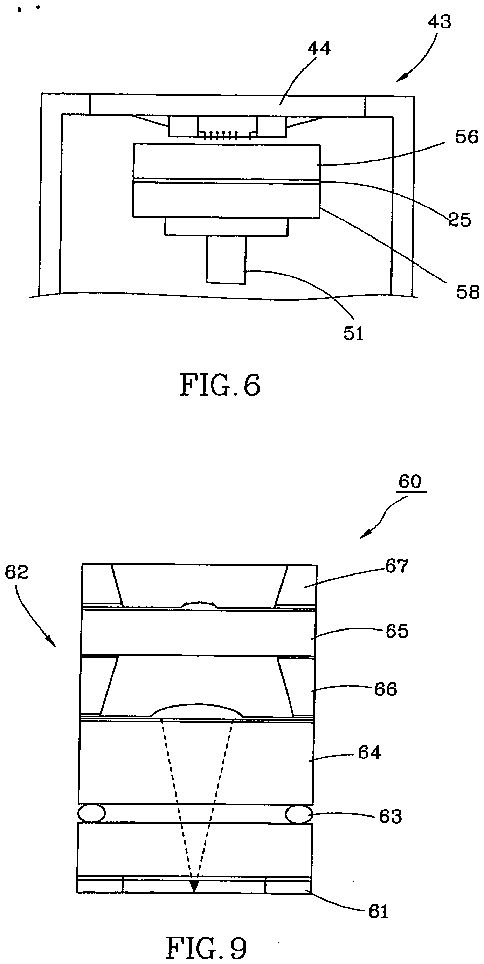

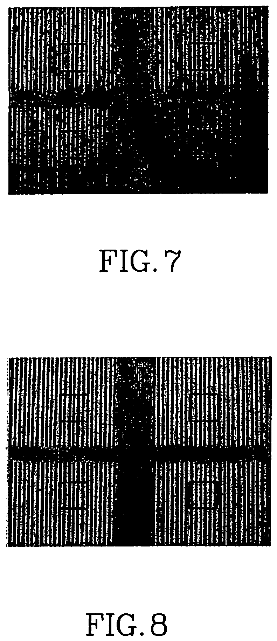

The assembly process of the wafer level image module **10** by the assembly apparatus **40** includes the following steps.
Step I: Perform an integrated circuit manufacturing process to prepare a first wafer **56.** As shown in FIG. 2, the first wafer has a plurality of photo sensors **20** each carrying a first alignment mark (not shown).
Step II: Perform an integrated circuit manufacturing process to prepare a second wafer **58,** which has a plurality of lens sets **30** each carrying a second alignment mark (not shown).
Step III: Place the first water **56** in the sliding carrier **52** of the assembly apparatus **40** and then stack the second wafer **58** on the first wafer **56** to have the second alignment marks of the lens sets **30** in alignment with the first alignment marks of the photo sensors **20** respectively, and then, as shown in FIG. 3, use the clamping device **54** to pre-bond the first wafer **56** and the second wafer **58** and to place the stacked first water **56** and second wafer **58** on the test table **51** to have the photo sensors **20** correspond to the probe card **44.**
Step IV: Control the test table **51** to electrically connect the stacked first water **56** and second wafer **58** to the probe card **44,** as shown in FIG. 4. The test table **50** can move the stacked wafers **56** and **58** horizontally or tilt the stacked first water **56** and the second wafer **58** subject to test requirements.
Step V: Operate the signal processor **46** to receive electrical signal from the signal pickup device **43** so as to obtain the focus offset in which the respective lens sets **30** map the image of incident light rays onto the respective photo sensors **20** for determining in-focus or out-of-focus status of the photo sensors **20** (see FIG. 5) and discriminating far coal or near focal status in case of out-of-focus status.
Step VI: Move the sliding carrier **52** out of the base **50,** and then apply the prepared adjustment member **25** to the first wafer **56** and the second wafer **58** to have the adjustment member **25** be sandwiched between the lens sets **30** and the photo sensors **20,** as shown in FIG. 6, and then electrically connect the integrated wafer level image modules of the stack of wafers **56** and **58** and adjustment member **25** to the probe card **44.**
Step VII: Repeat the aforesaid steps IV through VI if the improved image, as shown in FIG. 7, produced by the photo sensors **20** still lightly shows an out-of-focus status till the in-focus status shown in FIG. 8 where the adjustment member **25** accurately compensates the focus offset.
Step VIII: Operate the clamping device **54** to hold tight the first wafer **56** and the second wafer **58,** and then operate the bonding unit **48** to bond the first wafer **56,** the adjustment member **25** and the second wafer **58** together.
Step IX: Cut the stacked wafers **56** and **58** and adjustment member **25** into single chips, i.e., individual wafer level image modules **10.**

When the lens sets **30** of the second wafer **58** are stacked on the photo sensors **20** of the first wafer **56** by means of the aforesaid assembly apparatus **40** and the aforesaid assembly process, the signal processor **46** is used to check in-focus or out-of-focus status of the electrical signal received from the signal pickup device through the photo sensors **20.** If the photo sensors **20** are at an out-of-focus status, the thickness of the adjustment member **25** is adjusted to correct the out-of-focus status of the photo sensors **20** to an in-focus status, assuring image quality of the assembled wafer level image modules **10.** Further, by means of changing the thickness of the adjustment member **25,** the distance between the respective lens sets **30** and the respective photo sensors **20** is relatively adjusted, thereby accurately compensating the focus offset between the respective lens sets **30** and the respective photo sensors **20** so that the respective lens sets **30** accurately focus light rays onto the respective photo sensors **20.**

As stated above, the invention uses the structure of the adjustment member to have the wafer level image module provide a better image quality.

FIG. 9 shows a wafer level image module **60** in accordance with a second embodiment of the present invention. Similar to the aforesaid first embodiment of the present invention, the wafer level image module **60** comprises a photo sensor **61,** a lens set **62,** and an adjustment member **63** sandwiched between the photo sensor **60** and the lens set **62.** The main feature of this second embodiment is that the lens set **62** comprises a first lens layer **64,** a second lens layer **65,** a first transmissive pad **66** sandwiched between the first lens layer **64** and the second lens layer **65,** and a second transmissive pad **67** bonded to the top surface of the second lens layer **65** opposite to the first transmissive pad **66.** The first lens layer **64** is bonded to the adjustment member **63** above the photo sensor **61.** The first lens layer **64** and the second lens layer **65** are transparent for mapping the image of incident light rays onto the photo sensor **61.** This lens set **62** enables the wafer level image module **60** to have more image characteristics.

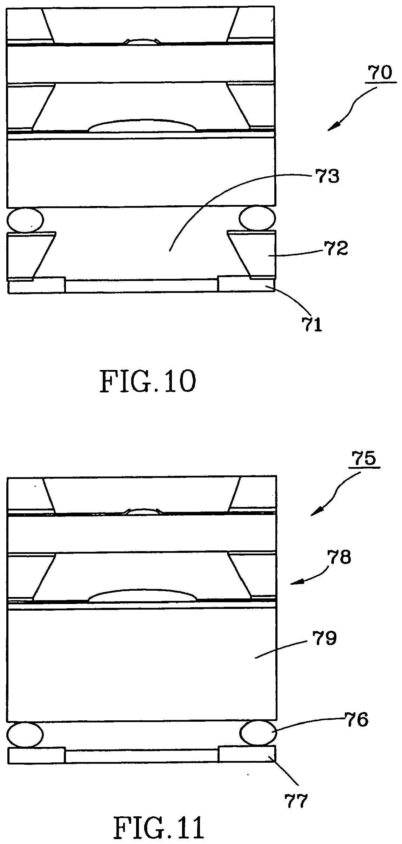

FIG. 10 shows a wafer level image module **70** in accordance with a third embodiment of the present invention. This third embodiment is substantially similar to the aforesaid second embodiment with the exception that the transmissive spacer **72** on the photo sensor **71** has an opening **73** corresponding to the photo sensing area of the photo sensor **71.** This third embodiment achieves the same various effects as the aforesaid first and second embodiments of the present invention.

FIG. 11 shows a wafer level image module **75** not forming part of the present invention. According to this not-claimed example the adjustment member **76** is directly bonded to the surface of the photo sensor **77,** and the first lens layer **79** of the lens set **78** is bonded to the adjustment member **76.**

## Claims

1. A wafer level image module (10) comprising:
a photo sensor (20) for outputting an electrical signal upon receiving light;
a lens set (30) for focusing incident light onto the photo sensor (20); and
a light transmissive spacer (22) and an adjustment member (25) formed on top of the light transmissive spacer (22) and disposed between the photo sensor (20) and the lens set (30) for controlling the distance between the photo sensor (20) and the lens set (30) for enabling the lens set (30) to focus the incident light onto the photo sensor (20) in an in-focus manner, **characterized in that** the adjustment member includes a glass ball spacer (25).

2. The wafer level image module as claimed in claim 1, wherein the lens set comprises a first transparent lens layer bonded to the adjustment member, a second transparent lens layer, and a light transmissive pad sandwiched between the first transparent lens layer and the second transparent lens layer.

3. The wafer level image module as claimed in claim 2, wherein the lens set further comprises a light transmissive pad bonded to a top surface of the second transparent lens layer opposite to the light transmissive pad that is sandwiched between the first transparent lens layer and the second transparent lens layer.

4. The wafer level image module as claimed in claim 1, wherein the light transmissive spacer has an opening corresponding to a photo sensing area of the photo sensor.

5. The wafer level image module as claimed in claim 1, wherein said photo sensor is a complementary metal-oxide semiconductor type photo sensor.

6. The wafer level image module as claimed in claim 1, wherein said adjustment member has a thickness ranging 1-50 µm.

7. A method for making a wafer level image module comprising the steps of:
a) providing a photo sensor (20) made by an integrated circuit manufacturing process;
b) stacking a lens set (30) made by an integrated circuit manufacturing process on the photo sensor (20);
c) measuring a focus offset of said lens set (30) and determining in-focus or out-of-focus status of said photo sensor (20); and
d) disposing a light transmissive spacer (22) and an adjustment member (25) on top of the light transmissive spacer (22) between said lens set (30) and said photo sensor (20) to compensate the focus offset of said lens set (30) so as to have said photo sensor (20) be in an in-focus status,
wherein the adjustment member includes a glass ball spacer (25).

8. The method as claimed in claim 7, wherein said step (c) comprises a sub-step of using a signal processor to check the out-of-focus status to be a far focal or near focal status when said photo sensor is in an out-of-focus status.

9. An apparatus adapted to in-situ assemble and test the wafer level image module of claim 1, the apparatus comprising:
a positioning unit adapted to position said photo sensor on said lens set and to provide said ligth transmissive spacer and said glass ball adjustment member between said photo sensor and said lens set;
a signal pickup device electrically connected to said photo sensor adapted to pick up a signal from said photo sensor upon focusing of an image onto said photo sensor by said lens set;
a signal processor electrically connected to said signal pickup device adapted to determine in-focus or out-of-focus status of the image focusing on the photo sensor; and
a bonding unit adapted to bond said photo sensor, said light transmissive spacer and said glass ball adjustment member and said lens set together.

10. The apparatus as claimed in claim 9, wherein said positioning unit comprises a clamping device adapted to clamp said photo sensor, said adjustment member and said lens set together for bonding by said bonding unit.

11. The apparatus as claimed in claim 9, wherein said positioning unit comprises a test table adapted to carry said wafer level image module and electrically connect said wafer level image module to said signal pickup device.

12. The apparatus as claimed in claim 9, wherein said signal pickup device comprises a probe card electrically connected to said photo sensor of said wafer level image module.

## Patentansprüche

1. Wafer-Level-Bildmodul (10), umfassend:
einen Fotosensor (20) zum Ausgeben eines elektrischen Signals nach einem Empfangen von Licht;
einen Linsensatz (30) zum Fokussieren einfallenden Lichts auf den Fotosensor (20); und
einen lichtdurchlässigen Abstandshalter (22) und ein Einstellelement (25), das auf der Oberseite des lichtdurchlässigen Abstandshalters (22) gebildet und zwischen dem Fotosensor (20) und dem Linsensatz (30) angeordnet ist, zum Steuern des Abstands zwischen dem Fotosensor (20) und dem Linsensatz (30) um dem Linsensatz (30) zu ermöglichen, das einfallende Licht auf den Fotosensor (20) auf eine fokussierte Art zu fokussieren,
**dadurch gekennzeichnet, dass** das Einstellelement einen Glaskugel-Abstandshalter (25) umfasst.

2. Wafer-Level-Bildmodul nach Anspruch 1, wobei der Linsensatz eine erste transparente Linsenschicht, die an das Einstellelement angebunden ist, eine zweite transparente Linsenschicht und ein lichtdurchlässiges Pad umfasst, das zwischen der ersten transparenten Linsenschicht und der zweiten transparenten Linsenschicht eingelegt ist.

3. Wafer-Level-Bildmodul nach Anspruch 2, wobei der Linsensatz ferner ein lichtdurchlässiges Pad aufweist, das an eine obere Oberfläche der zweiten transparenten Linsenschicht angebunden ist, gegenüber dem lichtdurchlässigen Pad, das zwischen der ersten transparenten Linsenschicht und der zweiten transparenten Linsenschicht eingelegt ist.

4. Wafer-Level-Bildmodul nach Anspruch 1, wobei der lichtdurchlässige Abstandshalter eine Öffnung aufweist, die einem fotosensitiven Bereich des Fotosensors entspricht.

5. Wafer-Level-Bildmodul nach Anspruch 1, wobei der Fotosensor ein Fotosensor vom Komplementär-Metalloxid-Halbleitertyp ist.

6. Wafer-Level-Bildmodul nach Anspruch 1, wobei das Einstellelement eine Dicke im Bereich von 1-50 µm aufweist.

7. Verfahren zur Herstellung eines Wafer-Level-Bildmoduls, umfassend die Schritte:
a) Bereitstellen eines Fotosensors (20), der durch einen Herstellungsprozess für integrierte Schaltungen hergestellt wurde;
b) Stapeln eines Linsensatzes (30), der durch einen Herstellungsprozess für integrierte Schaltungen hergestellt wurde, auf dem Fotosensor (20);
c) Messen eines Brennpunktversatzes des Linsensatzes (30) und Bestimmen eines fokussierten oder nichtfokussierten Status des Fotosensors (20); und
d) Anordnen eines lichtdurchlässigen Abstandshalters (22) und eines Einstellelements (25) oberhalb des lichtdurchlässigen Abstandshalters (22) zwischen dem Linsensatz (30) und dem Fotosensor (20), um den Brennpunktversatz des Linsensatzes (30) zu kompensieren, um den Fotosensor (20) in einen fokussierten Zustand zu versetzen,
wobei das Einstellelement einen Glaskugel-Abstandshalter (25) umfasst.

8. Verfahren nach Anspruch 7, wobei der Schritt (c) einen Unterschritt des Verwendens eines Signalprozessors umfasst, um den nichtfokussierten Zustand zu überprüfen, ob er ein weit-fokaler oder nah-fokaler Zustand ist, wenn der Fotosensor in einem nichtfokussierten Zustand ist.

9. Vorrichtung, angepasst zum in-situ-Zusammenbauen und Testen des Wafer-Level-Bildmoduls von Anspruch 1, wobei die Vorrichtung umfasst:
eine Positionierungseinheit, angepasst zum Positionieren des Fotosensors an dem Linsensatz und zum Bereitstellen des lichtdurchlässigen Abstandshalters und des Glaskugel-Einstellelements zwischen dem Fotosensor und dem Linsensatz;
eine Signalaufnahmevorrichtung, die elektrisch mit dem Fotosensor verbunden ist und angepasst ist zum Aufnehmen eines Signals von dem Fotosensor, nach dem Fokussieren eines Bildes auf dem Fotosensor durch den Linsensatz;
einen Signalprozessor, der elektrisch mit der Signalaufnahmevorrichtung verbunden ist und angepasst ist, um den fokussierten oder nichtfokussierten Zustand des auf den Fotosensor fokussierten Bildes zu bestimmen; und
eine Anbindungseinheit, angepasst zum Anbinden des Fotosensors, des lichtdurchlässigen Abstandshalters und des Glaskugel-Einstellelements und des Linsensatzes miteinander,

10. Vorrichtung nach Anspruch 9, wobei die Positionierungseinheit eine Klemmvorrichtung, angepasst zum Zusammenklemmen des Fotosensors, des Einstellelements und der Linseneinheit zum Anbinden durch die Anbindungseinheit umfasst.

11. Vorrichtung nach Anspruch 9, wobei die Positionierungseinheit einen Testtisch, angepasst zum Tragen des Wafer-Level-Bildmoduls und zum elektrischen Verbinden des Wafer-Level-Bildmoduls mit der Signalaufnahmevorrichtung umfasst.

12. Vorrichtung nach Anspruch 9, wobei die Signalaufnahmevorrichtung eine Prüfkarte umfasst, die elektrisch mit dem Fotosensor des Wafer-Level-Bildmoduls verbunden ist.

## Revendications

1. Module d'image au niveau de plaquette (10) comprenant :
un capteur de photos (20) pour produire un signal électrique à la réception de la lumière,
un jeu de lentilles (30) pour concentrer la lumière incidente sur le capteur de photos (20), et
une entretoise transmettant la lumière (22) et un élément d'ajustement (25) formé en haut de l' entretoise transmettant la lumière (22) et disposée entre le capteur de photos (20) et le jeu de lentilles (30) pour contrôler la distance entre le capteur de photos (20) et le jeu de lentilles (30) pour permettre au jeu de lentilles (30) de concentrer la lumière incidente sur le capteur de photos (20) d'une manière focalisée,
**caractérisé en ce que**
l'élément d'ajustement comprend une entretoise sphérique en verre (25).

2. Module d'image au niveau de plaquette selon la revendication 1, dans lequel le jeu de lentilles comprend une première couche de lentille transparente liée à l'élément d'ajustement, une deuxième couche de lentille transparente et une pastille transmettant la lumière prise en sandwich entre la première couche de lentille transparente et la deuxième couche de lentille transparente.

3. Module d'image au niveau de plaquette selon la revendication 2, dans lequel le jeu de lentilles comprend en plus une pastille transmettant la lumière liée à une surface supérieure de la deuxième couche de lentille transparente opposée à la pastille transmettant la lumière qui est prise en sandwich entre la première couche de lentille transparente et la deuxième couche de lentille transparente.

4. Module d'image au niveau de plaquette selon la revendication 1, dans lequel l'entretoise transmettant la lumière possède une ouverture correspondant à une zone de détection de photos du capteur de photos.

5. Module d'image au niveau de plaquette selon la revendication 1, dans lequel ledit capteur de photos est un capteur de photos de type à semi-conducteurs métal-oxyde complémentaire.

6. Module d'image au niveau de plaquette selon la revendication 1, dans lequel ledit élément d'ajustement a une épaisseur se situant dans une gamme de 1-50 µm.

7. Méthode pour la fabrication d'un module d'image au niveau de plaquette comprenant les étapes consistant à :
a) fournir un capteur de photos (20) réalisé par le processus de fabrication de circuit intégré,
b) empiler un jeu de lentilles (30) réalisé par le processus de fabrication de circuit intégré sur le capteur de photos (20),
c) mesurer un décalage de focalisation dudit jeu de lentilles (30) et déterminer l'état focalisé ou défocalisé dudit capteur de photos (20), et
d) disposer une entretoise transmettant la lumière (22) et un élément d'ajustement (25) en haut de l'entretoise transmettant la lumière (22) entre ledit jeu de lentilles (30) et ledit capteur de photos (20) pour compenser le décalage de focalisation dudit jeu de lentilles (30) de manière à avoir ledit capteur de photos (20) dans un état focalisé,
l'élément d'ajustement comprenant une entretoise sphérique en verre (25).

8. Méthode selon la revendication 7, dans laquelle ladite étape (c) comprend une sous-étape d'utilisation d'un processeur de signaux pour vérifier l'état déconcentré comme étant un état focal éloigné ou proche lorsque ledit capteur de photos se trouve dans un état défocalisé.

9. Appareil adapté pour le montage et le contrôle in situ du module d'image au niveau de plaquette selon la revendication 1, l'appareil comprenant :
une unité de positionnement adaptée pour positionner ledit capteur de photos sur ledit jeu de lentilles et pour fournir ladite entretoise transmettant la lumière et ledit élément d'ajustement sphérique en verre entre ledit capteur de photos et ledit jeu de lentilles ,
un dispositif capteur de signaux électriquement connecté audit capteur de photos adapté pour capter un signal dudit capteur de photos à la focalisation d'une image sur le capteur de photos par ledit jeu de lentilles,
un processeur de signaux électriquement connecté audit dispositif capteur de signaux adapté pour déterminer un état focalisé ou défocalisé de la concentration d'image sur le capteur de photos, et
une unité de liaison adaptée pour lier ledit capteur de photos, ladite entretoise transmettant la lumière et ledit élément d'ajustement sphérique en verre et ledit jeu de lentilles ensemble.

10. Appareil selon la revendication 9, dans lequel ladite unité de positionnement comprend conjointement un jeu de lentilles pour liaison par ladite unité de liaison.

11. Appareil selon la revendication 9, dans lequel ladite unité de positionnement comprend un tableau de contrôle adapté pour transporter ledit module d'image au niveau de plaquette et connecter électriquement ledit module d'image au niveau de plaquette audit dispositif capteur de signaux.

12. Appareil selon la revendication 9, dans lequel ledit dispositif capteur de signaux comprend une carte à pointe électriquement connecté audit capteur de photos dudit module d'image au niveau de plaquette.
